# EUROPEAN PATENT APPLICATION

(11) **EP 4 694 588 A1**
(43) Date of publication of application: **11.02.2026**
(21) Application number: 25191084.0
(22) Date of filing: 22.07.2025
(51) Int. Cl.: H05K 3/36, H05K 1/14

(54) **ELECTRICAL DEVICE, ELECTRIC DRIVE SYSTEM AND VEHICLE**

(30) Priority: 09.08.2024 CN 202421940504 U
(71) Applicant: Valeo eAutomotive Shenzhen Co., Ltd, Shenzhen Guangdong 518128 (CN)
(72) Inventor: ZHU, Yuncong, Shenzhen, 518128 (CN); HU, Dong, Shenzhen, 518128 (CN)
(74) Representative: Valeo Powertrain Systems

(57) **Abstract**

The present disclosure proposes an electrical device (10), comprising: a first circuit board (100), which is provided with a first mounting hole (150), and comprises a first outer surface and a first inner surface that are opposite each other; a second circuit board, which is provided with a second mounting hole, and comprises a second outer surface and a second inner surface that are opposite each other; and a conductive connecting post, comprising a first connecting end and a second connecting end, wherein the first circuit board and the second circuit board are arranged such that the first inner surface and the second inner surface are opposite each other; the first connecting end of the conductive connecting post is inserted into the first mounting hole and is welded to the first circuit board at the first mounting hole; and the second connecting end of the conductive connecting post is inserted into the second mounting hole and is welded to the second circuit board at the second mounting hole. The present disclosure also relates to an electric drive system, which comprises such an electrical device. The present disclosure also relates to a vehicle, which comprises such an electrical device or such an electric drive system.

## Description

### TECHNICAL FIELD

The present disclosure relates to an electrical device, and further relates to an electric drive system comprising such an electrical device, and further relates to a vehicle comprising such an electrical device or such an electric drive system.

### BACKGROUND

For electrical devices and electric drive systems, such as for vehicles, requirements for size reduction are increasingly pressing, for example, for adaptation to the development of weight reduction of vehicles, in particular electric vehicles or hybrid vehicles. Such an electrical device may comprise two circuit boards that are opposite each other and electrically connected to each other. In the prior art, a conductive connecting post, such as a copper post, is generally used to connect the two circuit boards in this way, and at least one end of the copper post in the prior art is electrically connected to one of the two circuit boards via a screw connection. Screw connections have several technical problems. A threaded hole on the circuit board tends to undergo thread wear, which is detrimental to a stable connection between the conductive connecting post and the circuit board. In addition, a screw connection generates a concentration of stress in the vicinity of the threaded hole on the circuit board, and the concentration of stress is detrimental to the performance of the circuit board; more specifically, an electronic component cannot be arranged in the region of stress concentration, which wastes space and is disadvantageous for product size reduction.

Therefore, there remains a need for a completely new solution which can overcome the problems in the prior art.

### SUMMARY OF THE INVENTION

For the reason above, according to one aspect of the present disclosure, an electrical device is proposed. According to an embodiment, the electrical device may comprise:
a first circuit board, which is provided with a first mounting hole, and comprises a first outer surface and a first inner surface that are opposite each other;
a second circuit board, which is provided with a second mounting hole, and comprises a second outer surface and a second inner surface that are opposite each other; and
a conductive connecting post, comprising a first connecting end and a second connecting end,
wherein: the first circuit board and the second circuit board are arranged such that the first inner surface and the second inner surface are opposite each other; the first connecting end of the conductive connecting post is inserted into the first mounting hole and is welded to the first circuit board at the first mounting hole; and the second connecting end of the conductive connecting post is inserted into the second mounting hole and is welded to the second circuit board at the second mounting hole.

Thus, the first connecting end and the second connecting end of the conductive connecting post are both correspondingly welded to one of the first circuit board and the second circuit board, which helps to realize an enduring stable connection between the respective circuit boards and the conductive connecting post, and a region of stress concentration is not generated; thus, required electronic components may be arranged near or around the first mounting hole and the second mounting hole on the first circuit board and the second circuit board, maximally utilizing space on the circuit board, helping to achieve a miniaturized construction.

According to various embodiments, the electrical device of present disclosure may further comprise one or more of the following further developments.

In some embodiments, the conductive connecting post further comprises an intermediate section that is arranged between the first connecting end and the second connecting end, and the intermediate section forms a widened section relative to the first connecting end and/or the second connecting end. Such a configuration facilitates assembly of the conductive connecting post to the first circuit board and the second circuit board.

In some embodiments, a diameter of the intermediate section is larger than a diameter of the first connecting end and/or the second connecting end.

In some embodiments, the first connecting end is soldered to the first circuit board by means of reflow soldering; the second connecting end is soldered to the second circuit board by means of wave soldering.

In some embodiments, the first connecting end does not protrude beyond the first outer surface; and/or the second connecting end protrudes from the second outer surface.

In some embodiments, a gap is provided between the intermediate section and the first inner surface and/or the second inner surface. This gap can avoid hard-to-hard bonding between the intermediate section of the conductive connecting post and the first circuit board and/or the second circuit board, particularly in a scenario with processing errors or assembly errors.

In some embodiments, the size of the gap is 0.2 mm to 0.5 mm.

In some embodiments, a diameter of the first mounting hole is larger than a diameter of the first connecting end; and/or a diameter of the second mounting hole is larger than a diameter of the second connecting end. Such a setting still enables insertion of the conductive connecting post into the corresponding first mounting hole and second mounting hole in a scenario with processing errors or assembly errors.

Another aspect of the present disclosure relates to an electric drive system, which may comprise the electrical device as described in any one of the embodiments above, and thus includes the corresponding advantages and benefits.

Another aspect of the present disclosure relates to a vehicle, which may comprise the electrical device according to any one of the above embodiments, or may comprise the electric drive system as described above.

### Brief Description of the Drawings

In order to explain the technical solution of embodiments of the present disclosure more clearly, the drawings that need to be used in the embodiments will be briefly described below. It should be understood that the drawings below show only some embodiments of the present disclosure, so they should not be regarded as limiting the scope. Those skilled in the art could obtain other related drawings based on these drawings without inventive effort. In the drawings:
Fig. 1 schematically shows an electrical device according to an exemplary embodiment in a three-dimensional exploded view;
Fig. 2 schematically shows a connection between a first circuit board and a second circuit board of an electrical device via an intermediary connecting post according to an exemplary embodiment in a planar view;
Fig. 3 schematically shows a connection between a first circuit board and a second circuit board via an intermediary connecting post in a partial cutaway view.

### Detailed Description of Embodiments

An electrical device, an electric drive system and a vehicle according to embodiments of the present disclosure are described in detail below with reference to the drawings. In order to make the objectives, technical solutions and advantages of the present practical disclosure clearer, the technical solutions in the embodiments of the present disclosure will be clearly and completely described below in conjunction with the drawings in the embodiments of the present disclosure; obviously, the embodiments described are some, not all, of the embodiments of the present disclosure.

Thus, the detailed description below of embodiments of the present disclosure provided in conjunction with the drawings is not intended to limit the claimed scope of the present disclosure, and merely shows selected embodiments of the present disclosure. All other embodiments obtained by those skilled in the art on the basis of the embodiments in the present disclosure without inventive effort are included in the scope of protection of the present disclosure.

Unless otherwise defined in the context, the singular form includes the plural form. In the entire specification, the terms "comprise", "have", and the like are used herein to specify the existence of the said features, numbers, steps, operations, elements, components, or combinations thereof, but do not exclude the existence or addition of one or more other features, numbers, steps, operations, elements, components, or combinations thereof.

In addition, even though terms including ordinal numbers such as "first" and "second" can be used to describe various components, these components are not restricted by these terms, which are merely used to distinguish one element from another. For example, without departing from the scope of the present disclosure, a first component may be called a second component and, similarly, a second component may be called a first component.

In the description of the present invention, it is necessary to understand that the orientation or position relationship indicated by terms such as "up", "down", "left", "right", "inside", and "outside" is based on the orientation or position relationship shown in the drawings, or the orientation or position relationship of usual placement when the disclosed product is in use, or the orientation or position relationship that is commonly understood by those skilled in the art, and is only for the convenience of describing the present disclosure and simplifying the description, rather than indicating or implying that the device or element referred to must have a specific orientation and be constructed and operated in a specific orientation, so must not be construed as limiting the present disclosure.

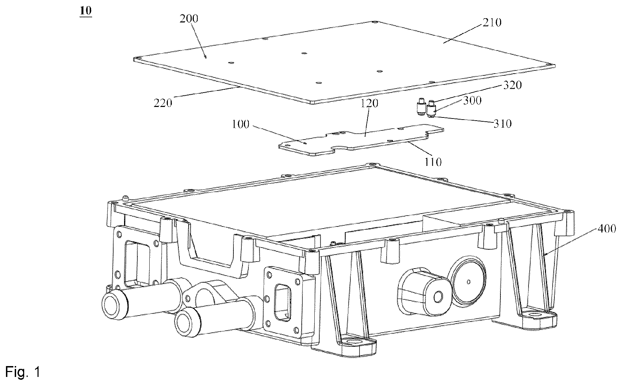

As shown in Figs. 1 - 3, one aspect of the present disclosure relates to an electrical device 10. In an exemplary application environment, the electrical device 10 is part of an electric drive system or a power supply module, e.g. part of an electric drive system or an on-board power supply module of an electric vehicle or a hybrid vehicle. It should be understood that an on-board power supply module may be used for charging an energy storage device (e.g. a supercapacitor or a battery external to the on-board power supply module); the on-board power supply module may receive filtered AC current input externally (e.g. from an external charging pile or charging apparatus) and rectifies and transforms the AC current into DC current, then delivers the current to a load or an energy storage device for charging, and, after the on-board power supply module has charged the energy storage device, a power conversion circuit generates driving power on the basis of the power from the energy storage device, to drive an electric motor to rotate.

According to an embodiment, the electrical apparatus 10 may comprise a first circuit board 100, a second circuit board 200 and a conductive connecting post 300. The first circuit board 100 is provided with a first mounting hole 150, and comprises an outer surface and an inner surface that are opposite each other, which hereinafter are respectively called a "first outer surface 110" and a "first inner surface 120". The second circuit board 200 is provided with a second mounting hole 250, and comprises an outer surface and an inner surface that are opposite each other, which hereinafter are respectively called a "second outer surface 210" and a "second inner surface 220". The first inner surface 120 of the first circuit board 100 and the second inner surface 220 of the second circuit board 200 are arranged opposite each other. The conductive connecting post 300 comprises a first connecting end 310 and a second connecting end 320. More specifically, the first connecting end 310 and the second connecting end 320 are respectively arranged at two opposite ends of the conductive connecting post 300. The first connecting end 310 of the conductive connecting post 300 is inserted into the first mounting hole 150 and is welded to the first circuit board 100 at the first mounting hole 150; the second connecting end 320 of the conductive connecting post 300 is inserted into the second mounting hole 250 and is welded to the second circuit board 200 at the second mounting hole 250. In a specific embodiment, the conductive connecting post 300 is a copper post, and an outer surface thereof is optionally tin-plated.

Thus, the first connecting end 310 and the second connecting end 320 of the conductive connecting post 300 are both correspondingly welded to one of the first circuit board 100 and the second circuit board 200, which helps to realize an enduring stable connection between the respective circuit boards and the conductive connecting post 300, and a region of stress concentration is not generated; thus, required electronic components may be arranged near or around the first mounting hole 150 and the second mounting hole 250 on the first circuit board 100 and the second circuit board 200, maximally utilizing space on the circuit board, helping to achieve a miniaturized construction.

In some embodiments, as shown in Figs. 1 - 3, the conductive connecting post 300 further comprises an intermediate section 330 that is arranged between the first connecting end 310 and the second connecting end 320, and the intermediate section 330 forms a widened section relative to the first connecting end 310 and/or the second connecting end 320. Such a configuration facilitates assembly of the conductive connecting post 300 to the first circuit board 100 and the second circuit board 200. In addition, the presence of the intermediate section 330 allows the presence of an accommodating space between the first circuit board 100 and the second circuit board 200, and an electronic element that is connected to the first inner surface 120 of the first circuit board 100 and/or the second inner surface 220 of the second circuit board 200 may be accommodated in the accommodating space. This allows more functional components to be integrated on the first circuit board 100 and/or the second circuit board 200. It should be noted that various electronic elements, such as surface-mount components, may be mounted on the first outer surface 110 and/or the first inner surface 120 of the first circuit board 100 and/or the second outer surface 210 and/or the second inner surface 220 of the second circuit board 200. In a specific embodiment, the conductive connecting post 300 is cylindrical, and a diameter of an intermediate section 330 is larger than a diameter of a first connecting end 310 and/or a second connecting end 320.

In some embodiments, the first connecting end 310 of the conductive connecting post 300 is soldered to the first circuit board 100 by means of reflow soldering. Alternatively or additionally, the second connecting end 320 of the conductive connecting post 300 is soldered to the second circuit board 200 by means of wave soldering. According to a specific embodiment, reflow soldering may first be used to solder a first connecting end 310 of a conductive connecting post 300 to a first circuit board 100; it should be understood that multiple surface-mount components must be mounted on the first circuit board 100, and reflow soldering can be performed on the multiple surface-mount components together with the first connecting end 310, thereby simplifying the process flow; then, wave soldering is further used to solder the second connecting end 320 of the conductive connecting post 300 to the second circuit board 200; it should be understood that, at this time, other multiple surface-mount components are already mounted on the second circuit board 200, so that wave soldering the second connecting end 320 does not affect the mounting of said other multiple surface-mount components, avoiding the surface-mount components falling off.

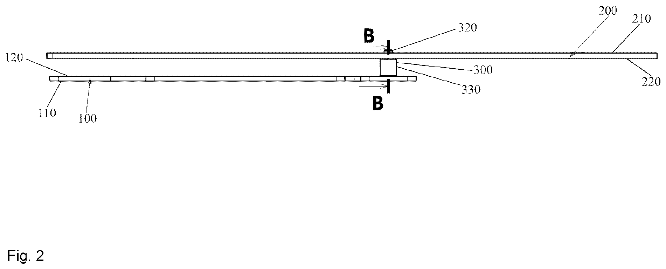

In some embodiments, as shown in Figs. 2 - 3, the first connecting end 310 of the conductive connecting post 300 is arranged to not protrude from the first outer surface 110. This further promotes compactness of the construction while allowing reflow soldering. Alternatively or additionally, the second connecting end 320 of the conductive connecting post 300 protrudes the second outer surface 210, which helps to form an effective soldering part for wave soldering.

In some embodiments, a gap is provided between the intermediate section 330 of the conductive connecting post 300 and the first inner surface 120 of the first circuit board 100 and/or the second inner surface 220 of the second circuit board 200. This gap can avoid hard-to-hard bonding between the intermediate section 330 of the conductive connecting post 300 and the first circuit board 100 and/or the second circuit board 200, particularly in a scenario with processing errors or assembly errors, thereby avoiding affecting the performance of the first circuit board 100 and/or the second circuit board 200. In some embodiments, the size of the gap is 0.2 mm to 0.5 mm.

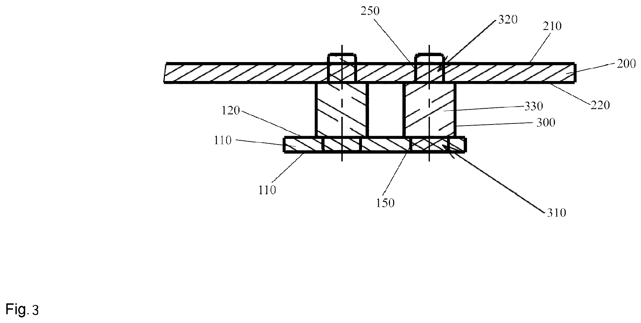

In some embodiments, as shown in Fig. 3, the diameter of the first mounting hole 150 of the first circuit board 100 may be set to be larger than the diameter of the first connecting end 310, and/or the diameter of the second mounting hole 250 of the second circuit board 200 may be set to be larger than the diameter of the second connecting end 320. Such a setting still enables insertion of the conductive connecting post 300 into the corresponding first mounting hole 150 and second mounting hole 250 in a scenario with processing errors or assembly errors.

As shown in Fig. 1, according to some embodiments, the electrical device further comprises a heat dissipation device 400, which may be configured to dissipate heat generated by electronic elements on the first circuit board 100 during operation.

Another aspect of the present disclosure relates to an electric drive system, which may comprise the electrical device 10 as described in any one of the embodiments above, and thus includes the corresponding advantages and benefits.

Another aspect of the present disclosure relates to a vehicle, which may comprise the electrical device 10 according to any one of the above embodiments, or may comprise the electric drive system as described above. According to various embodiments, the vehicle proposed by the present disclosure may be an electrified vehicle, such as a battery electric vehicle (BEV), a hybrid electric vehicle (HEV), a plug-in hybrid electric vehicle (PHEV), a range extended EV or a fuel cell electric vehicle (FCEV). The vehicle may also be a hydrogen-powered vehicle.

Demonstrative embodiments of the electrical device, the electric drive system and the vehicle proposed in the present disclosure have been described in detail above with reference to preferred embodiments. However, those skilled in the art will understand that without departing from the concept of the present disclosure, various modifications and alterations may be made to the specific embodiments above, and various technical features and structures proposed in the present disclosure may be combined in various ways, without exceeding the scope of protection of the present disclosure.

The scope of the present disclosure is not defined by the embodiments described above, but by the appended claims and their equivalent scope.

## Claims

1. An electrical device (10), **characterized in that** the electrical device comprises:
a first circuit board (100), which is provided with a first mounting hole (150), and comprises a first outer surface (110) and a first inner surface (120) that are opposite each other;
a second circuit board (200), which is provided with a second mounting hole (250), and comprises a second outer surface (210) and a second inner surface (220) that are opposite each other; and
a conductive connecting post (300), comprising a first connecting end (310) and a second connecting end (320),
wherein:
the first circuit board (100) and the second circuit board (200) are arranged such that the first inner surface (120) and the second inner surface (220) are opposite each other;
the first connecting end (310) of the conductive connecting post (300) is inserted into the first mounting hole (150) and is welded to the first circuit board (100) at the first mounting hole (150); and
the second connecting end (320) of the conductive connecting post (300) is inserted into the second mounting hole (250) and is welded to the second circuit board (200) at the second mounting hole (250).

2. The electrical device (10) according to Claim 1, **characterized in that**
the conductive connecting post (300) further comprises an intermediate section (330) that is arranged between the first connecting end (310) and the second connecting end (320), and the intermediate section (330) forms a widened section relative to the first connecting end (310) and/or the second connecting end (320).

3. The electrical device (10) according to Claim 2, **characterized in that**
a diameter of the intermediate section (330) is larger than a diameter of the first connecting end (310) and/or the second connecting end (320).

4. The electrical device (10) according to Claim 3, **characterized in that**
the first connecting end (310) is soldered to the first circuit board (100) by means of reflow soldering;
the second connecting end (320) is soldered to the second circuit board (200) by means of wave soldering.

5. The electrical device (10) according to Claim 4, **characterized in that**
the first connecting end (310) does not protrude beyond the first outer surface (110); and/or
the second connecting end (320) protrudes from the second outer surface (210).

6. The electrical device (10) according to any one of Claims 2 to 5,
**characterized in that**
a gap is provided between the intermediate section (330) and the first inner surface (120) and/or the second inner surface (220).

7. The electrical device (10) according to Claim 6, **characterized in that**
a size of the gap is 0.2 mm to 0.5 mm.

8. The electrical device (10) according to any one of Claims 1 to 5,
**characterized in that**
a diameter of the first mounting hole (150) is larger than a diameter of the first connecting end (310); and/or
a diameter of the second mounting hole (250) is larger than a diameter of the second connecting end (320).

9. An electric drive system, **characterized in that** the electric drive system comprises the electrical device (10) according to any one of Claims 1 to 8.

10. A vehicle, **characterized by** comprising the electrical device (10) according to any one of Claims 1 - 8, or comprising the electric drive system according to Claim 9.
